(19) Europäisches Patentamt / European Patent Office / Office européen des brevets

(11) **EP 3 185 098 B1**

(12) **FASCICULE DE BREVET EUROPEEN**

(45) Date de publication et mention
de la délivrance du brevet:
**29.11.2023   Bulletin 2023/48**

(21) Numéro de dépôt: **16202571.2**

(22) Date de dépôt: **07.12.2016**

(51) Classification Internationale des Brevets (IPC):
***G05F 1/67*** *(2006.01)*

(52) Classification Coopérative des Brevets (CPC):
**G05F 1/67**

(54) **PROCEDE POUR ESTIMER UNE ENERGIE EXCEDENTAIRE**

VERFAHREN ZUM SCHÄTZEN DER ÜBERSCHÜSSIGEN ENERGIE

METHOD FOR ESTIMATING SURPLUS ENERGY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **21.12.2015   FR 1563015**

(43) Date de publication de la demande:
**28.06.2017   Bulletin 2017/26**

(73) Titulaire: **SAGEMCOM ENERGY & TELECOM SAS
92500 Rueil-Malmaison (FR)**

(72) Inventeurs:
• **SABATIER, Pierre
92500 RUEIL MALMAISON (FR)**
• **TARDY-MARCANTONI, Romain
92500 RUEIL MALMAISON (FR)**

(74) Mandataire: **Lavaud, Thomas
Cabinet Boettcher
5, rue de Vienne
75008 Paris (FR)**

(56) Documents cités:
**WO-A1-2014/049269      FR-A1- 2 879 852
FR-A1- 2 941 328      US-A1- 2010 181 957**

• **DAKKAK M ET AL: "Operation strategy of
residential centralized photovoltaic system in
remote areas", RENEWABLE ENERGY,
PERGAMON PRESS, OXFORD, GB, vol. 28, no. 7,
1 June 2003 (2003-06-01), pages 997-1012,
XP004398674, ISSN: 0960-1481, DOI:
10.1016/S0960-1481(02)00222-7**

## Description

L'invention concerne le domaine des équipements électriques alimentés par un panneau solaire et par une batterie, et le domaine de l'estimation et de la récupération d'une énergie électrique excédentaire produite dans de tels équipements électriques.

### ARRIERE PLAN DE L'INVENTION

Dans certains pays où le taux d'ensoleillement est important, les opérateurs téléphoniques utilisent des installations comprenant des équipements électriques de télécommunication (par exemple, des antennes relais) alimentés grâce à un ou plusieurs panneaux solaires et à une ou plusieurs batteries. A Madagascar, plus de deux cents installations de ce type sont recensées.

Un équipement électrique de télécommunication d'une telle installation est classiquement alimenté par une tension continue de 48 Vdc. Les batteries confèrent une autonomie importante à l'installation (généralement, au moins cinq jours d'autonomie).

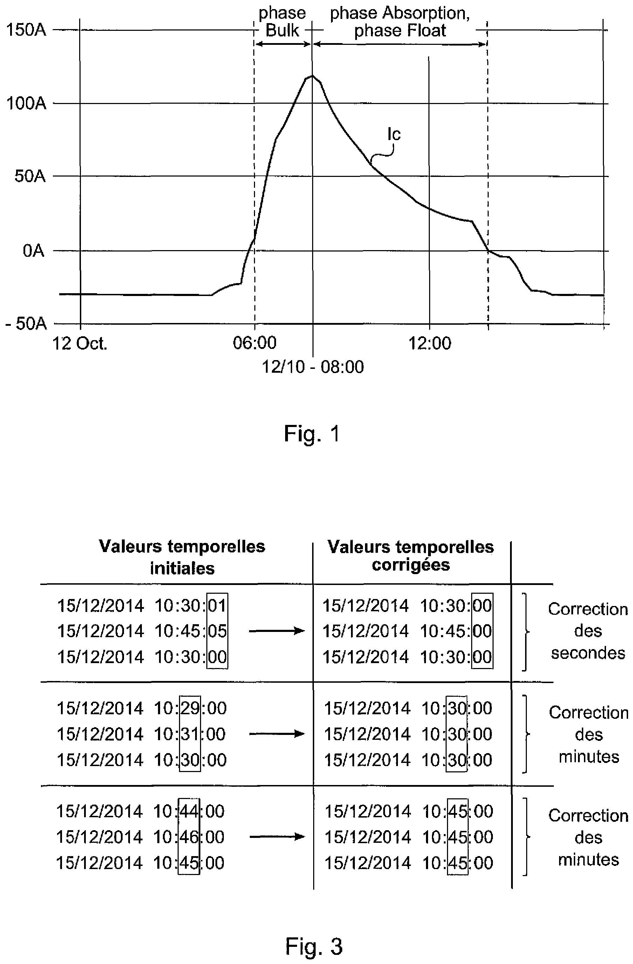

En référence à la figure 1, lorsque les batteries sont des batteries de type plomb-acide associées à des chargeurs de type I.Uo.U., la phase de charge dite « phase Bulk » de chaque batterie s'achève au cours de la matinée d'une journée donnée ou en fin de matinée de la journée donnée. Durant la phase Bulk, un courant de charge Ic des batteries est maximum et toute l'énergie électrique produite par les panneaux solaires est consommée par l'équipement électrique de télécommunication et par la charge des batteries. Après la phase Bulk commence la phase dite « phase Absorption » qui est elle-même suivie par la phase dite « phase Float ». Durant la phase Absorption et la phase Float, le courant de charge Ic des batteries diminue et une partie de l'énergie électrique produite par les panneaux solaires est inutilisée.

Il semble particulièrement intéressant d'estimer l'énergie excédentaire disponible dans les équipements électriques de télécommunication de telles installations. En estimant l'énergie excédentaire, on peut établir une cartographie des gisements solaires à l'échelle d'une région ou d'un pays. On peut ainsi, lorsqu'une installation présente un fort potentiel d'énergie excédentaire, mettre en œuvre une récupération et une distribution locale efficaces de cette énergie excédentaire. On peut aussi, lorsqu'une installation présente un faible potentiel d'énergie excédentaire, réétudier le dimensionnement de l'installation pour augmenter son potentiel d'énergie excédentaire afin de proposer des solutions de récupération et de distribution locale.

Le document FR 2 941 328 A1 dévoile un procédé de prévision de la production électrique d'un dispositif photovoltaïque.

Le document publiée par Elsevier intitulé "Operation strategy of residential centralized photovoltaic system in remote areas" (Dakkak M; Hirata A; Muhida R; Kawasaki Z) illustre un procédé pour estimer une énergie excédentaire disponible par un panneau solaire et qui n'a pas été utilisée par un équipement électrique connecté au panneau solaire et alimenté par une batterie.

### OBJET DE L'INVENTION

L'invention a pour objet d'estimer de manière efficace, simple et peu coûteuse l'énergie excédentaire disponible dans un équipement électrique alimenté par un panneau solaire et par une batterie.

### RESUME DE L'INVENTION

En vue de la réalisation de ce but, on propose un procédé pour estimer une énergie excédentaire disponible dans un équipement électrique alimenté par un panneau solaire et par une batterie, selon la revendication indépendante 1, ainsi que un concentrateur, un programme d'ordinateur et des moyens de stovkage selon les revendications indépendantes 13-15.

Lorsque la journée donnée est une journée de plein soleil, le moment où la courbe de rendement atteint la valeur maximale prédéterminée correspond au moment où la phase Bulk de la batterie s'achève. L'énergie excédentaire disponible correspond donc à la différence entre une énergie théorique et une énergie réelle fournies par le panneau solaire. Lorsque la journée donnée n'est pas une journée de plein soleil ou lorsque la courbe de rendement n'atteint pas la valeur maximale prédéterminée, la puissance théorique ne peut être produite dans son intégralité par le panneau solaire et est donc réajustée pour estimer l'énergie excédentaire disponible.

L'énergie excédentaire disponible est ainsi estimée de manière simple et efficace, sans utiliser de capteurs autres que des capteurs de courant et de tension habituellement utilisés dans des équipements électriques alimentés par un panneau solaire et par une batterie.

D'autres caractéristiques et avantages de l'invention ressortiront à la lecture de la description qui suit de modes de réalisation particuliers, non limitatifs de l'invention.

**EP 3 185 098 B1**

BREVE DESCRIPTION DES DESSINS

Il sera fait référence aux dessins annexés parmi lesquels :

- la figure 1 représente une courbe de charge d'une batterie d'une installation dans laquelle est mise en oeuvre le procédé de l'invention ;
- la figure 2 est un diagramme représentant des étapes du procédé de l'invention ;
- la figure 3 représente une liste de données de mesure avant et après une correction de leurs valeurs temporelles ;
- la figure 4 représente une liste de données de mesure présentant une période de temps manquante ;
- la figure 5 représente une liste de données de mesure présentant des données de mesure manquantes ;
- la figure 6 est un graphique qui comporte une courbe représentant les données de mesure de la figure 5 ;
- la figure 7 est un graphique qui comporte une courbe de puissance théorique et une courbe de puissance réelle monotone croissante depuis le lever du soleil jusqu'au maximum de la courbe ;
- la figure 8 est un graphique qui comporte une courbe de puissance théorique et une courbe de puissance réelle non monotone croissante depuis le lever du soleil jusqu'au maximum de la courbe ;
- la figure 9 est un tableau contenant des caractéristiques techniques d'un panneau solaire ;
- la figure 10 est un graphique qui comporte une courbe de puissance théorique et une courbe de puissance réelle d'une journée de plein soleil ;
- la figure 11 est un graphique qui comporte une courbe de puissance théorique et une courbe de puissance réelle d'une journée non ensoleillée ;
- les figures 12 et 13 sont des graphiques comportant des courbes de rendement d'une journée de plein soleil ;
- la figure 14 comprend trois graphiques comportant des courbes symbolisant l'estimation d'une énergie excédentaire lors d'une journée de plein soleil avec une courbe de rendement qui atteint une valeur maximale prédéterminée ;
- la figure 15 est un graphique comportant une courbe de rendement d'une journée non ensoleillée ;
- les figures 16 et 17 comprennent trois graphiques comportant des courbes symbolisant le calcul d'une énergie théorique ajustée ;
- la figure 18 comprend deux graphiques comportant des courbes symbolisant l'estimation d'une énergie excédentaire lors d'une journée non ensoleillée ;
- la figure 19 comprend deux graphiques comportant des courbes symbolisant l'estimation d'une énergie excédentaire lors d'une journée de plein soleil avec une courbe de rendement qui n'atteint pas la valeur maximale prédéterminée.

DESCRIPTION DETAILLEE DE L'INVENTION

L'invention est ici mise en oeuvre dans une installation comprenant un équipement électrique de télécommunication, en l'occurrence une antenne relais. Outre l'antenne relais, l'installation comporte une pluralité de batteries, un chargeur de batteries, une pluralité de panneaux solaires, des capteurs, des moyens de traitement et des moyens de communication.

Les batteries sont des batteries de type plomb-acide. Le chargeur de batteries est un chargeur de type I.Uo.U. Les batteries et les panneaux solaires sont utilisés pour alimenter électriquement l'ensemble de l'installation.

Les capteurs comportent des capteurs de température qui mesurent notamment une température ambiante, des voltmètres qui mesurent notamment des tensions aux bornes des panneaux solaires, des tensions aux bornes des batteries, et une tension aux bornes de l'antenne relais, et des ampèremètres qui mesurent notamment des courants fournis par les panneaux solaires, des courants utilisés pour charger les batteries, et un courant consommé par l'antenne relais et par l'ensemble de l'installation.

Les moyens de traitement acquièrent un certain de nombre de données de mesure fournies par les capteurs. Les données de mesure comportent des données de température, des donnée de tension, des données d'intensité, des données relatives à un état de charge des batteries (ou « SOC » pour State Of Charge).

Les moyens de communication permettent à l'antenne relais de transmettre les données de mesure à un concentrateur de données externe.

Le concentrateur de données externe reçoit des données de mesures provenant de l'installation dont il est ici question et d'une pluralité d'autres d'installations semblables comprenant des équipements électriques de télécommunication tels que l'antenne relais.

Le procédé de l'invention, qui permet d'estimer une énergie excédentaire disponible dans l'antenne relais (et dans les équipements électriques de télécommunication de la pluralité d'autres installation) est mis en oeuvre dans le concentrateur de données externe.

Le procédé de l'invention consiste tout d'abord, pour une journée donnée, à définir une courbe de puissance réelle et une courbe de puissance théorique fournies par les panneaux solaires en fonction du temps, puis à définir une courbe de rendement à partir de la courbe de puissance réelle et de la courbe de puissance théorique.

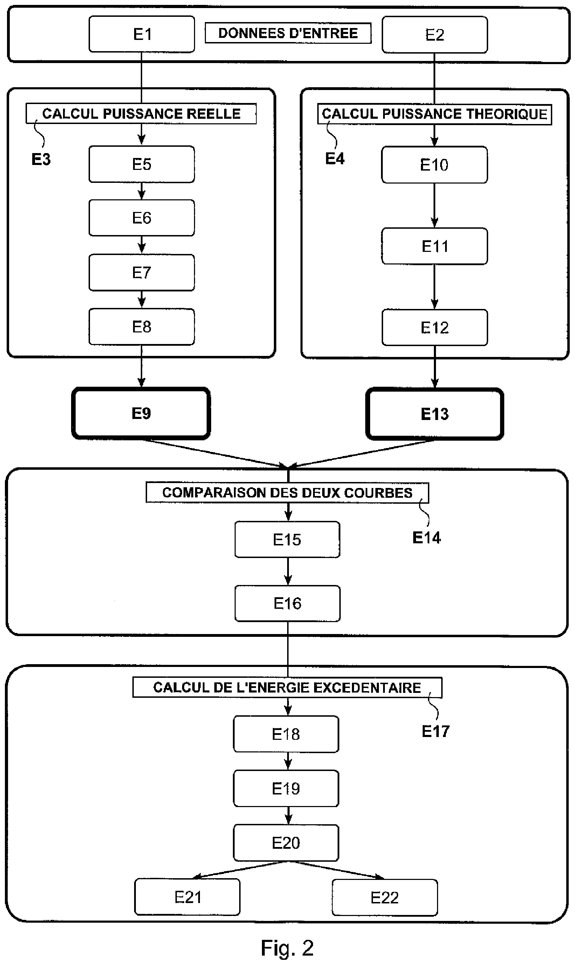

En référence à la figure 2, le procédé de l'invention comporte l'étape d'acquérir les données de mesure transmises par l'antenne relais (étape E1), et l'étape d'acquérir un certain nombre de paramètres et caractéristiques techniques associés aux panneaux solaires de l'installation (étape E2).

Les données de mesure transmises par l'antenne relais sont utilisées pour estimer une puissance réelle fournie par les panneaux solaires et pour définir une courbe de puissance réelle (étape E3).

Les paramètres et caractéristiques techniques associés aux panneaux solaires de l'installation sont utilisés pour estimer une puissance théorique fournie par les panneaux solaires et pour définir une courbe de puissance théorique (étape E4).

On décrit tout d'abord la manière dont est estimée la puissance réelle et dont est définie la courbe de puissance réelle.

La puissance réelle est estimée à partir des données de tension et des données d'intensité comprises dans les données de mesure.

Pour définir la courbe de puissance réelle, les données de mesure subissent tout d'abord un certain nombre de corrections qui permettent de rendre les données de mesure exploitables.

Les données de mesure sont ici générées avec un pas de temps normalement égal à quinze minutes (c'est-à-dire que des données de mesure successives sont acquises et enregistrées par les moyens de traitement à quinze minutes d'intervalle). Cependant, les données de mesure sont parfois enregistrées avec un léger décalage temporel. Les données de mesure sont corrigées de manière à ce qu'un pas de temps entre des données de mesure successives soit toujours égal à une durée de pas constante, ici égale précisément à quinze minutes (étape E5) .

Ainsi, en référence à la figure 3, les valeurs temporelles initiales représentant la date et l'heure des données de mesure sont corrigées de manière à obtenir des valeurs temporelles corrigées. La correction consiste à remplacer les valeurs de minute 14 et 16 par la valeur 15, les valeurs de minute 01 et 59 par la valeur 00, les valeurs de minute 29 et 31 par la valeur 30, les valeurs de minute 44 et 46 par la valeur 45. Les valeurs de seconde non nulles sont quant à elles remplacées par la valeur 00.

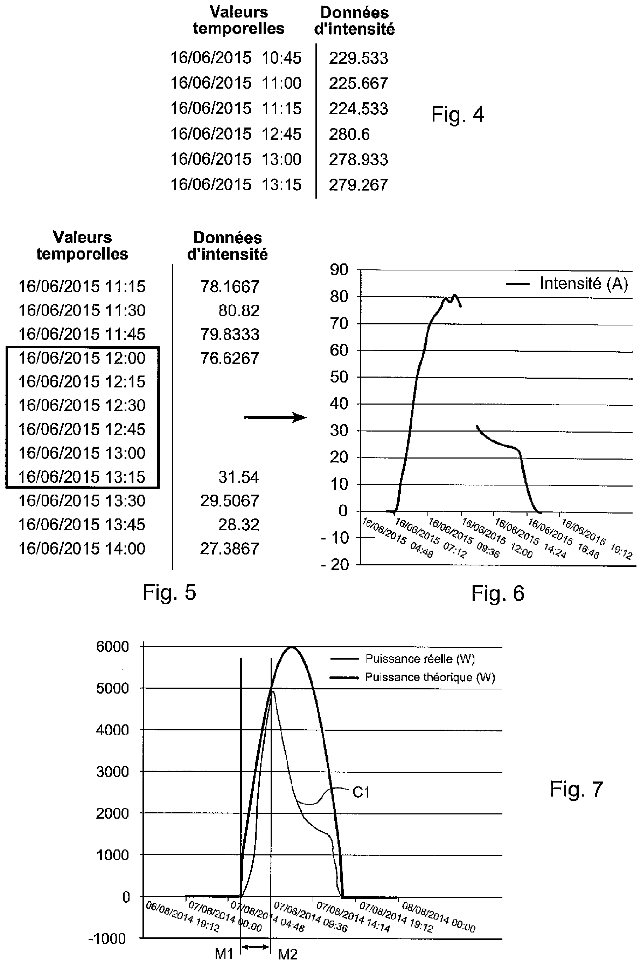

Lorsque des périodes de temps sont manquantes, pour une journée donnée, entre un moment correspondant au lever du soleil et un moment correspondant au coucher du soleil, l'ensemble des données de mesure sont éliminées pour la journée donnée (étape E6). Par « période de temps manquante », on entend une période entière où aucune valeur temporelle et aucune donnée de mesure ne sont disponibles pendant un intervalle de temps. Ainsi, sur la figure 4, l'intervalle de temps entre les valeurs temporelles « 16/06/2015, 11 : 15 » et « 16/06/2015, 12 :45 » (non incluses) correspond à une période de temps manquante. La journée donnée n'est donc pas prise en compte pour estimer l'énergie excédentaire disponible dans l'antenne relais.

Lorsque des données de mesure sont manquantes, pour une journée donnée, entre un moment correspondant au lever du soleil et un moment correspondant au coucher du soleil, l'ensemble des données de mesure sont éliminées pour la journée donnée (étape E7). Ainsi, sur les figures 5 et 6, les données d'intensité dans l'intervalle de temps entre les valeurs temporelles « 16/06/2015, 12 : 00 » et « 16/06/2015, 13 :15 » (non incluses) sont manquantes. La journée donnée n'est pas prise en compte pour estimer l'énergie excédentaire disponible dans l'antenne relais.

On détermine ensuite si la journée donnée est une journée de plein soleil ou non (étape E8). Les journées de plein soleil sont des journées pendant lesquelles les conditions optimales sont réunies pour que les panneaux solaires produisent le maximum d'énergie possible.

Pour être considérée comme une journée de plein soleil, la journée donnée doit satisfaire à deux critères.

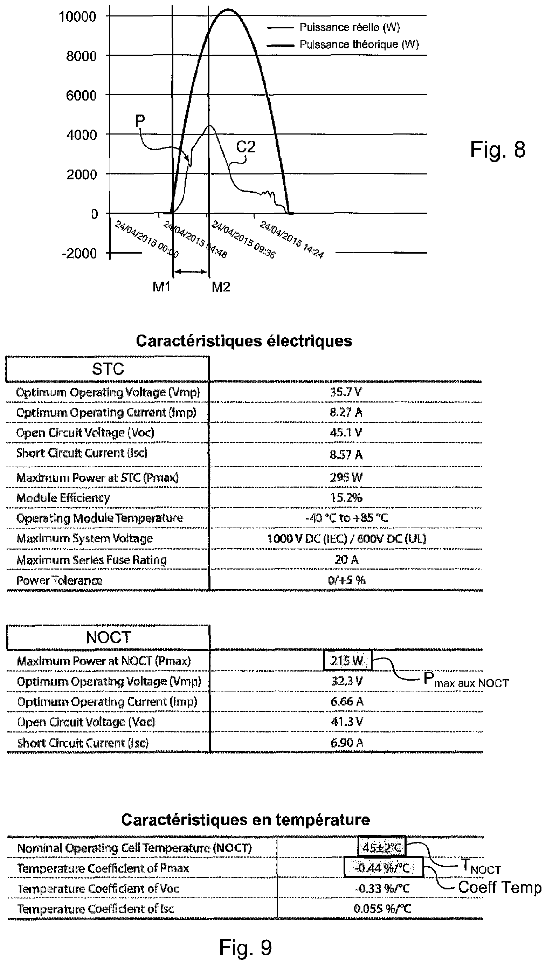

Un premier critère concerne les variations de la puissance réelle mesurée au cours de la journée donnée. Le premier critère pour considérer qu'une journée donnée est une journée de plein soleil est rempli si la courbe de puissance réelle est une courbe croissante monotone à partir d'un moment M1 correspondant au lever du soleil jusqu'à un moment M2 où la courbe de puissance réelle atteint sa valeur maximale. La courbe de puissance réelle C1 de la figure 7 est bien une courbe croissante monotone : le premier critère est donc rempli. Au contraire, la courbe de puissance réelle C2 de la figure 8 n'est pas une courbe monotone croissante à partir du moment M1 jusqu'au moment M2 (la courbe de puissance réelle est décroissante au point P) : le premier critère n'est pas rempli.

Un deuxième critère concerne l'état de charge des batteries lors de la journée donnée. Le deuxième critère pour considérer qu'une journée donnée est une journée de plein soleil est rempli lorsque les données de mesure comportent au moins une valeur d'état de charge de l'une des batteries inférieure ou égale à un seuil d'état de charge prédéterminé. Le seuil d'état de charge prédéterminé est ici égal à 95%. On traite ainsi les journées dans lesquelles au moins une batterie est bien déchargée au lever du jour, de manière à observer une forte croissance de la courbe de charge des batteries et donc de la puissance réelle. On supprime par ailleurs les journées lors desquelles une valeur d'enregistrement d'erreur de l'état de charge est présente.

On a ainsi déterminé si la journée donnée est bien une journée de plein soleil, et on a défini la courbe de puissance réelle (étape E9).

On décrit désormais la manière dont est estimée la puissance théorique et dont est définie la courbe de puissance théorique.

La puissance théorique de la pluralité de panneaux solaires est calculée à partir de l'irradiance globale théorique de chaque panneau solaire.

L'irradiance globale théorique de chaque panneau solaire est tout d'abord estimée grâce à l'équation ci-dessous (étape E10) :

$$\text{Ipanneau} = \text{Iincident.} \left[\cos \alpha * \sin \beta * \cos(\varphi - \theta) + \sin \alpha * \cos \beta\right],$$

où :

Ipanneau est l'irradiance globale d'un panneau solaire ;
Iincident est l'irradiance incidente d'un panneau solaire ;
$\alpha$ est l'angle d'élévation du soleil ;
$\theta$ est l'angle d'azimut ;
$\beta$ est l'inclination du panneau ;
$\varphi$ : un panneau solaire dans l'hémisphère sud sera orienté face au nord avec $\varphi$ = 0° et un panneau solaire dans l'hémisphère nord sera généralement directement orienté face au sud avec $\varphi$ = 180°.

Les angles d'élévation et d'azimut utilisés cidessus sont obtenus à partir de données de position du soleil en fonction de la latitude, de la longitude et de l'altitude correspondant à un endroit où est située l'installation, et de la date. Les données de position du soleil proviennent ici d'une librairie obtenue via un logiciel de type PyEphem (sous Python).

La puissance théorique fournie par un panneau solaire est ensuite calculée à partir de l'irradiance globale théorique du panneau solaire (étape E11).

La puissance théorique d'un panneau solaire dépend d'un paramètre appelé ici $P_{\text{max aux NOCT}}$ (paramètre visible dans le tableau de caractéristiques d'un panneau solaire de la figure 9) qui est une estimation d'une puissance maximale fournie par le panneau solaire aux conditions dites NOCT (pour « Normal Operating Cell Température ») qui correspondent aux conditions suivantes :

Irradiance = 800W/m$^2$ ;
Température ambiante = 20°C ;
Coefficient Air Mass = 1,5 ;
Vitesse du vent = 1 m/s.

La puissance théorique d'un panneau solaire se calcule par la formule suivante :

$$P_{panneau} = \frac{Ipanneau \left(\frac{W}{m^2}\right)}{800} * P_{max\ aux\ NOCT}.$$

Des pertes de puissance liées à la température des cellules des panneaux solaires sont prises en compte dans le calcul. Lorsque la température des cellules est supérieure à une température nominale, l'efficacité d'un panneau solaire diminue proportionnellement au Coefficient de Température *Coeff Temp* (paramètre visible dans le tableau de la figure 9).

On calcule tout d'abord la température d'une cellule d'un panneau solaire, qui est liée à la température ambiante, à l'irradiance et à la valeur de la température $T_{NOCT}$ sous conditions NOCT (paramètre visible dans le tableau de la figure 9) par la formule suivante :

$$T_{cellule}(°C) = T_{ambiante}(°C) + \frac{Ipanneau \left(\frac{W}{m^2}\right)}{800} * (T_{NOCT}(°C) - 20).$$

Les pertes de puissance liées à la température des cellules sont calculées ainsi :

$$P_{pertes\ tempé} = P_{panneau} * \frac{\left|Coeff\ Temp \frac{\%}{°C}\right|}{800} * (T_{cellule} - T_{NOCT}).$$

La puissance théorique totale, pour un panneau solaire, correspond à la puissance théorique résultant de l'irradiance auxquelles les pertes de puissance liées à la température des cellules sont retranchées. Pour un nombre N total de panneaux solaires de l'installation, on obtient donc une puissance théorique :

$$P_{\text{théo totale}} = N * (P_{panneau} - P_{pertes\ tempé}).$$

On calcule ensuite l'heure du lever de soleil théorique (étape E12).

On a ainsi déterminé l'heure du lever de soleil théorique, et on a définit la courbe de puissance théorique (étape E13).

Puis, les courbes de puissance réelle et de puissance théorique sont comparées (étape E14).

Les journées de plein soleil dans lesquelles l'heure de lever du soleil réelle est supérieure d'au moins une heure à l'heure de lever de soleil théorique sont supprimées (étape E15).

La courbe de rendement est ensuite définie à partir de la courbe de puissance théorique et de la courbe de puissance réelle (étape E16). Le rendement R est calculé selon la formule suivante :

R = Pr/Pt, où Pr est la puissance réelle et Pt la puissance théorique qui correspond à la $P_{\text{théo totale}}$ calculée plus tôt.

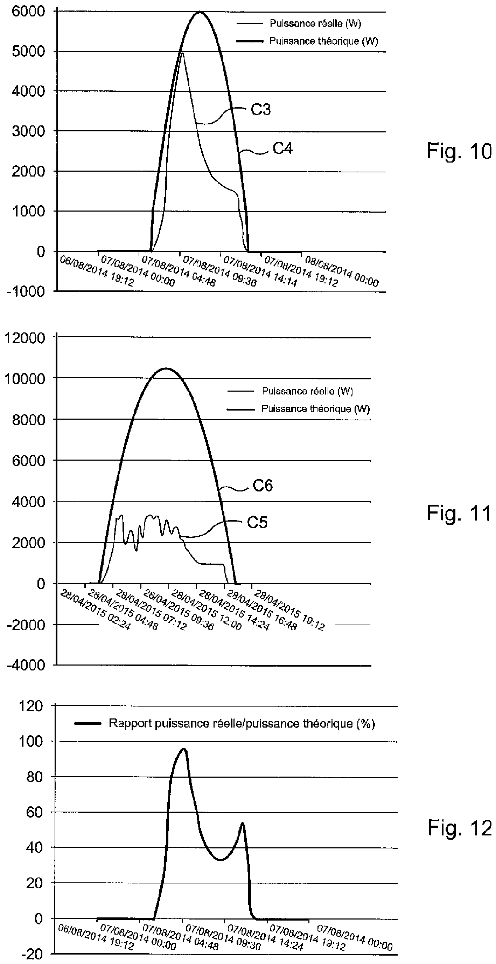

On voit sur la figure 10 que, lors d'une journée de plein soleil, une courbe de puissance réelle C3 rejoint une courbe de puissance théorique C4. Au contraire, on voit sur la figure 11 que, lors d'une journée non ensoleillée, une courbe de puissance réelle C5 ne rejoint pas une courbe de puissance théorique C6.

On comprend que lors des journées de plein soleil, la courbe de puissance réelle présente une évolution relativement similaire à celle de la courbe de la figure 1 qui représente un courant de charge de la batterie. Ainsi, lors d'une journée de plein soleil, la fin de la phase Bulk correspond à un moment où la courbe de puissance réelle se confond avec la courbe de puissance théorique.

Une courbe de rendement pour une journée donnée, telle que la courbe de rendement visible sur la figure 12, permet notamment, pour les journées de plein soleil, d'évaluer le moment où la courbe de puissance réelle se confond avec la courbe de puissance théorique. Lorsqu'il est atteint, ce moment correspond à un maximum de la courbe de rendement.

On note que la méthode de calcul de rendement est simple à mettre en oeuvre de manière automatique, notamment dans le cas d'un très grand nombre de données de mesure disponibles (quelques centaines de millions de données de mesure sont par exemple disponibles chaque année pour un pays comme Madagascar, où sont situées environ deux cents installations telles que celle évoquée ici).

L'ensemble des données évoquées plus tôt est ensuite utilisé pour estimer une énergie excédentaire disponible lors de la journée donnée (étape E17).

L'énergie excédentaire disponible correspond à l'énergie électrique fournie par les panneaux solaires qui n'a pas été utilisée pour charger la batterie et pour alimenter l'antenne relais et le reste de l'installation.

Pour estimer l'énergie excédentaire disponible lors de la journée donnée, on commence par déterminer un premier moment h1 de la journée donnée et un deuxième moment h2 de la journée donnée (étape E18). Le premier moment h1 est proche du deuxième moment h2. Le deuxième moment h2 correspond au moment où la courbe de rendement atteint sa valeur maximale. Le premier moment h1 correspond ici à un moment où la courbe de rendement atteint un certain pourcentage prédéfini de la valeur maximale de la courbe de rendement. Le certain pourcentage prédéfini est ici égal à 90%.

Lorsqu'une valeur de puissance réelle fournie par le panneau solaire à un moment situé entre le premier moment h1 et le deuxième moment h2 est manquante, l'énergie excédentaire disponible pour la journée donnée n'est pas estimée (étape E19).

Lorsque plusieurs valeurs de puissance réelle fournie par les panneaux solaires et correspondant à une période située hors de l'intervalle compris entre le premier moment h1 et le deuxième moment h2 sont manquantes, et que la durée de la période est inférieure à une durée prédéterminée, une extrapolation linéaire est réalisée pour obtenir la courbe de puissance réelle (étape E20). Ici, la durée prédéterminée est égale à deux heures.

Si une seule des valeurs de puissance réelle fournie par les panneaux solaires au premier moment h1 et au deuxième moment h2 est disponible pour la journée donnée, les valeurs de puissance réelles prises en compte pour le premier moment h1 et le deuxième moment h2 sont celles du premier moment h1 et du deuxième moment h2 d'une journée de plein soleil précédant la journée donnée.

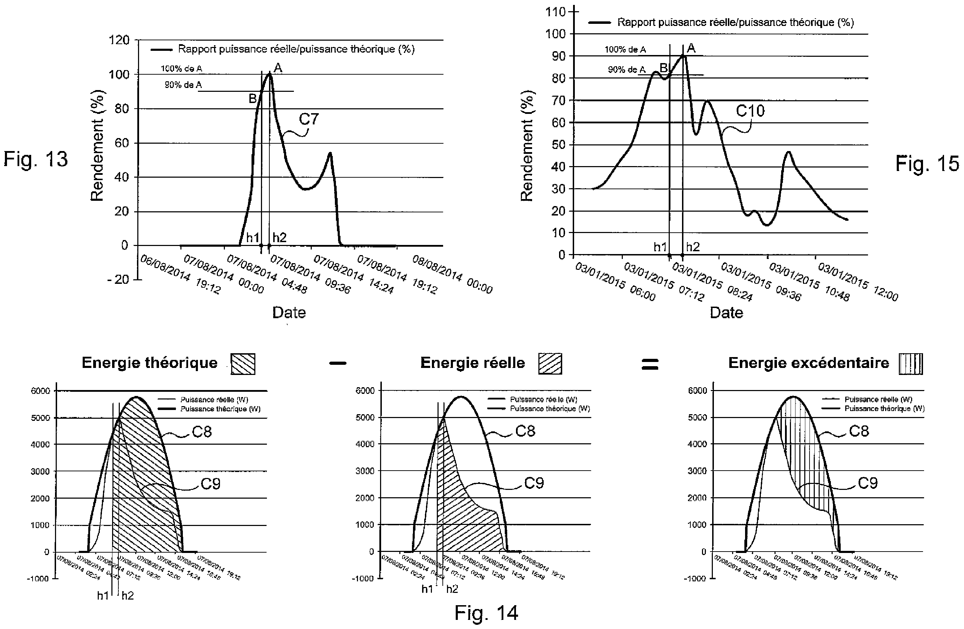

En référence aux figures 13 et 14, lorsque la journée est une journée de plein soleil et que la courbe de rendement C7 atteint une valeur maximale prédéterminée, on estime l'énergie excédentaire disponible en retranchant à la courbe de puissance théorique C8 la courbe de puissance réelle C9 à partir du premier moment h1, puis en calculant une intégrale de la courbe obtenue entre le premier moment h1 et la fin de la journée (étape E21). La valeur maximale prédéterminée est ici égale à 1 (100%) : le deuxième moment h2 correspond donc à un moment où la puissance réelle est égale à la puissance théorique, et donc à un moment où la courbe de puissance réelle C9 rejoint la courbe de puissance théorique C8.

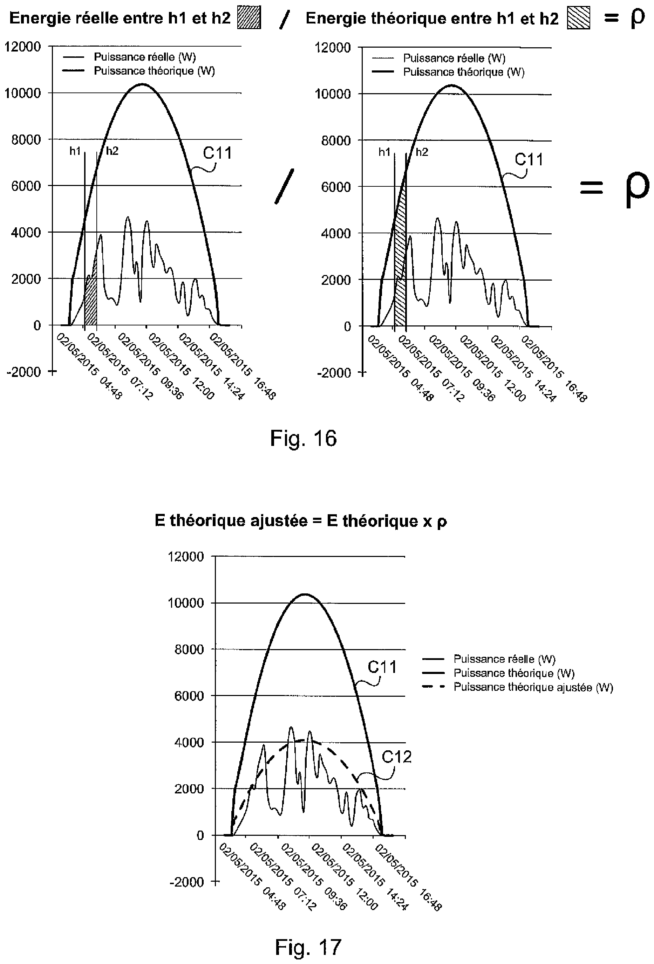

En référence aux figures 15 à 17, lorsque la journée donnée n'est pas une journée de plein soleil ou bien que la courbe de rendement C10 n'atteint pas la valeur maximale prédéterminée, on ajuste la courbe théorique de puissance C11, qui est basée sur un ensoleillement optimal, en fonction de l'ensoleillement du jour.

On multiplie la courbe de puissance théorique C11 par une valeur $\rho$ qui correspond au rapport entre une énergie réelle fournie par les panneaux solaires calculée entre le premier moment h1 et le deuxième moment h2 et entre une énergie théorique fournie par les panneaux solaires calculée entre le premier moment h1 et le deuxième moment h2. On obtient alors une courbe de puissance théorique ajustée C12.

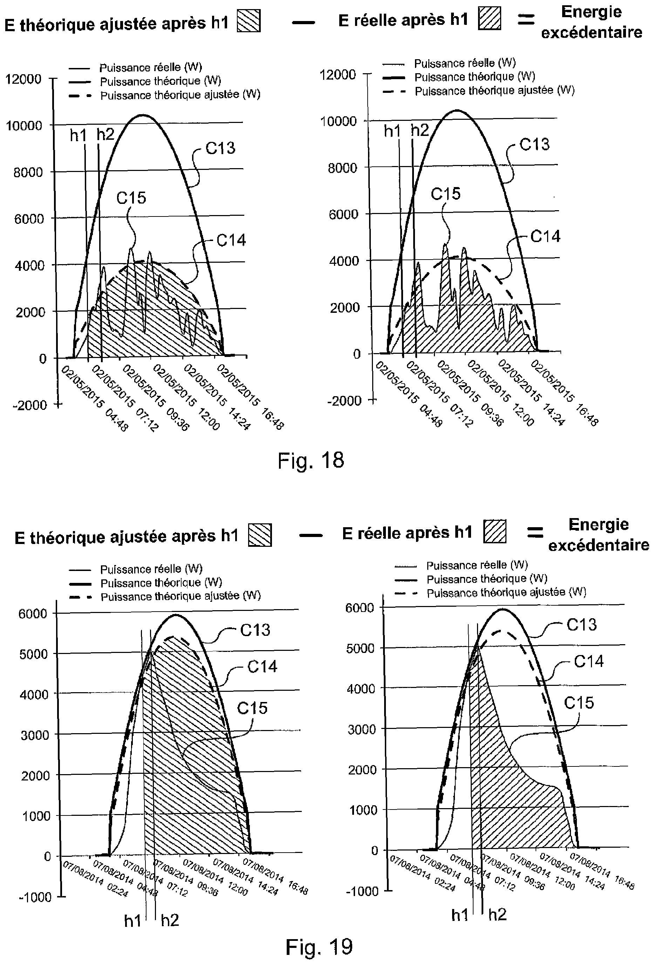

En référence aux figures 18 et 19, on estime alors l'énergie excédentaire disponible en ajustant la courbe de puissance théorique C13 pour obtenir une courbe de puissance théorique ajustée C14, puis en retranchant à la courbe de puissance théorique ajustée C14 la courbe de puissance réelle C15 à partir du premier moment h1 de la journée. L'énergie excédentaire disponible est estimée en calculant une intégrale de la courbe obtenue entre le premier moment h1 et la fin de la journée (étape E22).

La figure 18 correspond à une journée donnée qui n'est pas une journée de plein soleil. La figure 19 correspond à une journée de plein soleil lors de laquelle la courbe de rendement atteint une valeur proche de la valeur maximale prédéterminée, mais inférieure tout de même à la valeur maximale prédéterminée.

Bien entendu, l'invention n'est pas limitée au mode de réalisation décrit mais englobe toute variante entrant dans le champ de l'invention telle que définie par les revendications.

Bien que l'on ait indiqué que l'équipement électrique de télécommunication est une antenne relais, l'invention s'applique bien sûr à un équipement électrique de télécommunication différent, et même à tout type d'équipement électrique alimenté par au moins une batterie et par au moins un panneau solaire.

**Revendications**

1. Procédé pour estimer une énergie excédentaire disponible dans un équipement électrique alimenté par un panneau solaire et par une batterie, **caractérisé en ce que** le procédé comporte, pour une journée donnée, l'étape de mesurer grâce à des capteurs une tension aux bornes du panneau solaire et un courant fourni par le panneau solaire, et les étapes, mises en oeuvre dans un concentrateur de données :

   - de définir une courbe de puissance théorique (C4, C6, C8, C11) et une courbe de puissance réelle (C1, C2, C3, C5, C9) fournies par le panneau solaire en fonction du temps, la courbe de puissance réelle étant obtenue définie à partir des mesures de tension et de courant ;
   - de déterminer si la journée est une journée de plein soleil ou non ;
   - de définir une courbe de rendement à partir de la courbe de puissance théorique et de la courbe de puissance réelle, le rendement étant égal au rapport entre la puissance réelle et la puissance théorique ;
   - lorsque la courbe de rendement atteint une valeur maximale prédéterminée et que la journée donnée est une journée de plein soleil, d'estimer l'énergie excédentaire disponible en retranchant à la courbe de puissance théorique la courbe de puissance réelle à partir d'un premier moment (h1) de la journée donnée proche d'un deuxième moment (h2) de la journée donnée où la courbe de rendement atteint sa valeur maximale, le premier moment (h1) de la journée donnée correspondant à un moment où la courbe de rendement atteint un certain pourcentage prédéfini de sa valeur maximale ;
   - lorsque la courbe de rendement n'atteint pas la valeur maximale prédéterminée ou bien que la journée donnée n'est pas une journée de plein soleil, d'estimer l'énergie excédentaire disponible en ajustant la courbe de puissance théorique pour obtenir une courbe de puissance théorique ajustée (C12, C14), puis en retranchant à la courbe de puissance théorique ajustée la courbe de puissance réelle à partir du premier moment de la journée.

2. Procédé selon la revendication 1, dans lequel l'ajustement de la courbe de puissance théorique consiste à multiplier la courbe de puissance théorique par un rapport entre une énergie réelle fournie par le panneau solaire calculée entre le premier moment (h1) et le deuxième moment (h2) et entre une énergie théorique fournie par le panneau solaire calculée entre le premier moment et le deuxième moment.

3. Procédé selon la revendication 1, dans lequel le certain pourcentage prédéfini est égal à 90%.

4. Procédé selon l'une des revendications précédentes, dans lequel, si une seule des valeurs de puissance réelle fournies par le panneau solaire au premier moment et au deuxième moment est disponible, les valeurs de puissance réelle prises en compte pour le premier moment et le deuxième moment sont celles du premier moment et du deuxième moment d'une journée de plein soleil précédant la journée donnée.

5. Procédé selon l'une des revendications précédentes, dans lequel, si une valeur de puissance réelle fournie par le panneau solaire à un moment situé entre le premier moment et le deuxième moment est manquante, l'énergie excédentaire disponible pour la journée donnée n'est pas estimée.

6. Procédé selon l'une des revendications précédentes, dans lequel, si des valeurs de puissance réelle fournies par le panneau solaire correspondant à une période non située entre le premier moment et le deuxième moment sont manquantes, une extrapolation linéaire est réalisée pour obtenir la courbe de puissance réelle si la durée de la période est inférieure à une durée prédéterminée.

7. Procédé selon la revendication 6, dans lequel la durée prédéterminée est égale à deux heures.

8. Procédé selon l'une des revendications précédentes, dans lequel les données de mesure sont corrigées de sorte qu'un pas de temps entre deux données de mesure se succédant soit toujours égal à une durée de pas constante.

9. Procédé selon la revendication 8, dans lequel la durée de pas constante est égale à 15 minutes.

10. Procédé selon l'une des revendications précédentes, dans lequel on détermine que la journée donnée est une journée de plein soleil lorsque la courbe de puissance réelle est monotone à partir d'un moment correspondant au lever du soleil jusqu'à un moment où la courbe de puissance réelle atteint sa valeur maximale, et lorsque les données de mesure comportent au moins une valeur d'état de charge de la batterie inférieure ou égale à un seuil d'état de charge prédéterminé.

11. Procédé selon la revendication 10, dans lequel le seuil d'état de charge prédéterminé est égal à 95%.

12. Procédé selon l'une des revendications précédentes, dans lequel la valeur maximale prédéterminée est égale à 1.

13. Concentrateur de données adapté à recevoir les mesures de tension et de courant et à mettre en oeuvre le procédé selon l'une des revendications précédentes.

14. Programme d'ordinateur comprenant des instructions pour mettre en oeuvre, par un concentrateur de données, le procédé selon l'une des revendications 1 à 12.

15. Moyens de stockage, **caractérisés en ce qu'**ils stockent un programme d'ordinateur comprenant des instructions pour mettre en oeuvre, par un concentrateur de données, le procédé selon l'une des revendications 1 à 12.

**Patentansprüche**

1. Verfahren zum Schätzen einer überschüssigen Energie, die in einer elektrischen Ausrüstung verfügbar ist, die von einem Solarpanel und von einer Batterie gespeist wird, **dadurch gekennzeichnet, dass** das Verfahren für einen gegebenen Tag den Schritt des Messens einer Spannung an den Klemmen des Solarpanels und eines von dem Solarpanel gelieferten Stroms mit Hilfe von Sensoren und die Schritte umfasst, die in einem Datenkonzentrator durchgeführt werden:

- Definieren einer theoretischen Leistungskurve (C4, C6, C8, C11) und einer realen Leistungskurve (C1, C2, C3, C5, C9), die von dem Solarpanel in Abhängigkeit von der Zeit geliefert werden, wobei die reale Leistungskurve anhand der Spannungs- und Strommessungen definiert erhalten wird;
- Bestimmen, ob der Tag ein Tag mit vollem Sonnenschein ist oder nicht;
- Definieren einer Ertragskurve anhand der theoretischen Leistungskurve und der realen Leistungskurve, wobei der Ertrag gleich dem Verhältnis zwischen der realen Leistung und der theoretischen Leistung ist;
- wenn die Ertragskurve einen vorbestimmten maximalen Wert erreicht und wenn der gegebene Tag ein Tag mit vollem Sonnenschein ist, Schätzen der verfügbaren überschüssigen Energie, indem von der theoretischen Leistungskurve die reale Leistungskurve ab einem ersten Zeitpunkt (h1) des gegebenen Tages nahe einem zweiten Zeitpunkt (h2) des gegebenen Tages, zu dem die Ertragskurve ihren maximalen Wert erreicht, abgezogen wird, wobei der erste Zeitpunkt (h1) des gegebenen Tages einem Zeitpunkt entspricht, zu dem die Ertragskurve einen bestimmten vordefinierten Prozentsatz ihres maximalen Werts erreicht;

- wenn die Ertragskurve den vorbestimmten maximalen Wert nicht erreicht oder wenn der gegebene Tag kein Tag mit vollem Sonnenschein ist, Schätzen der verfügbaren überschüssigen Energie, indem die theoretische Leistungskurve angepasst wird, um eine angepasste theoretische Leistungskurve (C12, C14) zu erhalten, und dann von der angepassten theoretischen Leistungskurve die reale Leistungskurve ab dem ersten Zeitpunkt des Tages abgezogen wird.

2. Verfahren nach Anspruch 1, bei dem die Anpassung der theoretischen Leistungskurve darin besteht, die theoretische Leistungskurve mit einem Verhältnis zwischen einer von dem Solarpanel gelieferten realen Energie, die zwischen dem ersten Zeitpunkt (h1) und dem zweiten Zeitpunkt (h2) berechnet wird, und zwischen einer von dem Solarpanel gelieferten theoretischen Energie, die zwischen dem ersten Zeitpunkt und dem zweiten Zeitpunkt berechnet wird, zu multiplizieren.

3. Verfahren nach Anspruch 1, bei dem der bestimmte vordefinierte Prozentsatz gleich 90% ist.

4. Verfahren nach einem der vorhergehenden Ansprüche, bei dem, wenn nur einer der Werte der realen Leistung, die von dem Solarpanel zu dem ersten Zeitpunkt und dem zweiten Zeitpunkt geliefert werden, verfügbar ist, die Werte der realen Leistung, die für den ersten Zeitpunkt und den zweiten Zeitpunkt berücksichtigt werden, diejenigen des ersten Zeitpunkts und des zweiten Zeitpunkts eines Tages mit vollem Sonnenschein sind, der dem gegebenen Tag vorausgeht.

5. Verfahren nach einem der vorhergehenden Ansprüche, bei dem, wenn ein realer Leistungswert, der von dem Solarpanel zu einem Zeitpunkt geliefert wird, der zwischen dem ersten Zeitpunkt und dem zweiten Zeitpunkt liegt, fehlt, die verfügbare überschüssige Energie für den gegebenen Tag nicht geschätzt wird.

6. Verfahren nach einem der vorhergehenden Ansprüche, bei dem, wenn von dem Solarpanel gelieferte reale Leistungswerte, die einer Periode entsprechen, die nicht zwischen dem ersten Zeitpunkt und dem zweiten Zeitpunkt liegt, fehlen, eine lineare Extrapolation durchgeführt wird, um die reale Leistungskurve zu erhalten, wenn die Dauer der Periode geringer als eine vorbestimmte Dauer ist.

7. Verfahren nach Anspruch 6, bei dem die vorbestimmte Dauer gleich zwei Stunden ist.

8. Verfahren nach einem der vorhergehenden Ansprüche, bei dem die Messdaten derart korrigiert werden, dass ein Zeitschritt zwischen zwei Messdaten, die aufeinander folgen, immer gleich einer konstanten Schrittdauer ist.

9. Verfahren nach Anspruch 8, bei dem die konstante Schrittdauer gleich 15 Minuten ist.

10. Verfahren nach einem der vorhergehenden Ansprüche, bei dem man bestimmt, dass der gegebene Tag ein Tag mit vollem Sonnenschein ist, wenn die reale Leistungskurve ab einem Zeitpunkt, der dem Sonnenaufgang entspricht, bis zu einem Zeitpunkt, an dem die reale Leistungskurve ihren maximalen Wert erreicht, monoton ist, und wenn die Messdaten mindestens einen Wert für den Ladezustand der Batterie umfassen, der niedriger oder gleich einem Schwellenwert für den vorbestimmten Ladezustand ist.

11. Verfahren nach Anspruch 10, bei dem der vorbestimmte Schwellenwert für den Ladungszustand gleich 95% ist.

12. Verfahren nach einem der vorhergehenden Ansprüche, bei dem der vorbestimmte maximale Wert gleich 1 ist.

13. Datenkonzentrator, der geeignet ist, die Spannungs- und Strommessungen zu empfangen und das Verfahren nach einem der vorhergehenden Ansprüche durchzuführen.

14. Computerprogramm, umfassend Anweisungen zum Durchführen des Verfahrens nach einem der Ansprüche 1 bis 12 mittels eines Datenkonzentrators.

15. Speichermittel, **dadurch gekennzeichnet, dass** sie ein Computerprogramm speichern, das Anweisungen umfasst, um mittels eines Datenkonzentrators das Verfahren nach einem der Ansprüche 1 bis 12 durchzuführen.

**EP 3 185 098 B1**

**Claims**

1. A method of estimating available excess energy in electrical equipment powered by a solar panel and by a battery, the method comprising, for a given day, the step of using sensors for measuring voltage across the terminals of the solar panel and current supplied by the solar panel, and the following steps that are performed in a data concentrator:

· defining a theoretical power curve (C4, C6, C8, C11) and a real power curve (C1, C2, C3, C5, C9) for the power supplied by the solar panel as a function of time, the real power curve being obtained from the voltage and current measurements;
· determining whether or not the day is a day of full sunshine;
· defining an efficiency curve from the theoretical power curve and from the real power curve, the efficiency being equal to the ratio of the real power divided by the theoretical power; and
· when the efficiency curve reaches a predetermined maximum value and the given day is a day of full sunshine, estimating the available excess energy by subtracting the real power curve from the theoretical power curve as from a first moment (h1) of the given day close to a second moment (h2) of the given day at which the efficiency curve reaches its maximum value, the first moment (h1) of the given day corresponds to a moment at which the efficiency curve reaches a certain predefined percentage of its maximum value; or
· when the efficiency curve does not reach the predetermined maximum value or the given day is not a day of full sunshine, estimating the available excess energy by adjusting the theoretical power curve to obtain an adjusted theoretical power curve (C12, C14), and then subtracting the real power curve from the adjusted theoretical power curve as from that first moment of the day.

2. A method according to claim 1, wherein the adjustment of the theoretical power curve consists in multiplying the theoretical power curve by the ratio of the real energy supplied by the solar panel as calculated between the first moment (h1) and the second moment (h2) divided by the theoretical energy supplied by the solar panel as calculated between the first moment and the second moment.

3. A method according to claim 1, wherein the certain predefined percentage is equal to 90%.

4. A method according to any preceding claim, wherein, if only one of the real power values supplied by the solar panel at the first moment and at the second moment is available, the real power values that are taken into account for the first moment and for the second moment are the values for the first moment and for the second moment of a day of full sunshine preceding the given day.

5. A method according to any preceding claim, wherein, if a value of the real power supplied by the solar panel at a moment situated between the first moment and the second moment is missing, then the available excess energy for the given day is not estimated.

6. A method according to any preceding claim, wherein, if the real power value supplied by the solar panel corresponding to a period that is not situated in the range from the first moment to the second moment are missing, the linear extrapolation is performed to obtain the real power curve if the duration of the period is shorter than a predetermined duration.

7. A method according to claim 6, wherein the predetermined duration is equal to two hours.

8. A method according to any preceding claim, wherein the measurement data is corrected so that a time step between two successive data measurements is always equal to an interval of constant duration.

9. A method according to claim 8, wherein the interval of constant duration is equal to 15 minutes.

10. A method according to any preceding claim, wherein it is determined that the given day is a day of full sunshine when the real power curve is monotonic from a moment corresponding to sunrise to a moment at which the real power curve reaches its maximum value, and when the measurement data includes at least one charge state value for the battery that is less than or equal to a predetermined state of charge threshold.

11. A method according to claim 10, wherein the predetermined state of charge threshold is equal to 95%.

12. A method according to any preceding claim, wherein the predetermined maximum value is equal to 1.

**13.** A data concentrator adapted to receive voltage and current measurements and to perform the method according to any preceding claim.

**14.** A computer program including instructions for enabling a data concentrator to perform the method according to any one of claims 1 to 12.

**15.** Storage means, **characterized in that** they store a computer program including instructions for enabling a data concentrator to perform the method according to any one of claims 1 to 12.

Fig. 1

| Valeurs temporelles initiales | Valeurs temporelles corrigées | |
|---|---|---|
| 15/12/2014 10:30:01<br>15/12/2014 10:45:05 ⟶<br>15/12/2014 10:30:00 | 15/12/2014 10:30:00<br>15/12/2014 10:45:00<br>15/12/2014 10:30:00 | Correction des secondes |
| 15/12/2014 10:29:00<br>15/12/2014 10:31:00 ⟶<br>15/12/2014 10:30:00 | 15/12/2014 10:30:00<br>15/12/2014 10:30:00<br>15/12/2014 10:30:00 | Correction des minutes |
| 15/12/2014 10:44:00<br>15/12/2014 10:46:00 ⟶<br>15/12/2014 10:45:00 | 15/12/2014 10:45:00<br>15/12/2014 10:45:00<br>15/12/2014 10:45:00 | Correction des minutes |

Fig. 3

**DONNEES D'ENTREE**

E1

E2

**CALCUL PUISSANCE REELLE**

E3

E5

E6

E7

E8

**CALCUL PUISSANCE THEORIQUE**

E4

E10

E11

E12

E9

E13

**COMPARAISON DES DEUX COURBES**

E14

E15

E16

**CALCUL DE L'ENERGIE EXCEDENTAIRE**

E17

E18

E19

E20

E21

E22

Fig. 2

| Valeurs temporelles | Données d'intensité | |
|---|---|---|
| 16/06/2015 10:45 | 229.533 | |
| 16/06/2015 11:00 | 225.667 | |
| 16/06/2015 11:15 | 224.533 | Fig. 4 |
| 16/06/2015 12:45 | 280.6 | |
| 16/06/2015 13:00 | 278.933 | |
| 16/06/2015 13:15 | 279.267 | |

| Valeurs temporelles | Données d'intensité |
|---|---|
| 16/06/2015 11:15 | 78.1667 |
| 16/06/2015 11:30 | 80.82 |
| 16/06/2015 11:45 | 79.8333 |
| 16/06/2015 12:00 | 76.6267 |
| 16/06/2015 12:15 | |
| 16/06/2015 12:30 | |
| 16/06/2015 12:45 | |
| 16/06/2015 13:00 | |
| 16/06/2015 13:15 | 31.54 |
| 16/06/2015 13:30 | 29.5067 |
| 16/06/2015 13:45 | 28.32 |
| 16/06/2015 14:00 | 27.3867 |

Fig. 5

Fig. 6

Fig. 7

Fig. 8

## Caractéristiques électriques

| STC | |
|---|---|
| Optimum Operating Voltage (Vmp) | 35.7 V |
| Optimum Operating Current (Imp) | 8.27 A |
| Open Circuit Voltage (Voc) | 45.1 V |
| Short Circuit Current (Isc) | 8.57 A |
| Maximum Power at STC (Pmax) | 295 W |
| Module Efficiency | 15.2% |
| Operating Module Temperature | -40 °C to +85 °C |
| Maximum System Voltage | 1000 V DC (IEC) / 600V DC (UL) |
| Maximum Series Fuse Rating | 20 A |
| Power Tolerance | 0/+5 % |

| NOCT | |
|---|---|
| Maximum Power at NOCT (Pmax) | 215 W  ⟵ P max aux NOCT |
| Optimum Operating Voltage (Vmp) | 32.3 V |
| Optimum Operating Current (Imp) | 6.66 A |
| Open Circuit Voltage (Voc) | 41.3 V |
| Short Circuit Current (Isc) | 6.90 A |

## Caractéristiques en température

| | |
|---|---|
| Nominal Operating Cell Temperature (NOCT) | 45±2°C  ⟵ T NOCT |
| Temperature Coefficient of Pmax | -0.44 %/°C |
| Temperature Coefficient of Voc | -0.33 %/°C  ⟵ Coeff Temp |
| Temperature Coefficient of Isc | 0.055 %/°C |

Fig. 9

15

Fig. 10

Fig. 11

Fig. 12

Fig. 15

Fig. 13

Fig. 14

**Energie réelle entre h1 et h2** ▨ **/ Energie théorique entre h1 et h2** ▨ **= ρ**

**/** **= ρ**

Fig. 16

**E théorique ajustée = E théorique x ρ**

Fig. 17

**Fig. 18**

**Fig. 19**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• FR 2941328 A1

**Littérature non-brevet citée dans la description**

• **DAKKAK M ; HIRATA A ; MUHIDA R ; KAWASAKI Z.** Operation strategy of residential centralized photovoltaic system in remote areas. Elsevier